# EUROPEAN PATENT APPLICATION

(11) **EP 4 443 234 A1**
(43) Date of publication of application: **09.10.2024**
(21) Application number: 23191602.4
(22) Date of filing: 16.08.2023
(51) Int. Cl.: G03F 1/24, G03F 1/54

(54) **BLANKMASK FOR EUV LITHOGRAPHY WITH ABSORBING FILM, AND PHOTOMASK FABRICATED WITH THE SAME**

(30) Priority: 03.04.2023 KR 20230043334; 27.07.2023 KR 20230097937
(71) Applicant: S&S Tech Co., Ltd., Daegu 42714 (KR)
(72) Inventor: PARK, Min-Kyu, 42714 Daegu (KR); WOO, Mi-Kyung, 42714 Daegu (KR); PARK, Min-Kwang, 42714 Daegu (KR); YANG, Chul-Kyu, 42714 Daegu (KR)
(74) Representative: ABG Intellectual Property Law, S.L.

(57) **Abstract**

Blankmask for EUV lithography has a reflective film formed on a substrate and an absorbing film formed on the reflective film. The absorbing film contains tantalum (Ta) and antimony (Sb). The absorbing film has a composition ratio of Ta:Sb = 2:8 - 6:4 at%. The absorbing film with a high extinction coefficient (k) allows for the thin film deposition of the absorbing film, reducing the Shadowing Effect and 3D Effect.

## Description

### CROSS-REFERENCE TO RELATED THE APPLICATION

This application is based on and claims priority to Korean Patent Applications No. 10-2023-0043334 filed on April 03, 2023 and No. 10-2023-0097937 filed on July 27, 2023 in the Korean Intellectual Property Office, the disclosure of which is incorporated by reference herein in its entirety.

### BACKGROUND

### Field

The present invention relates to a blankmask and photomask, and more particularly, to an Extreme Ultraviolet (EUV) lithography blankmask equipped with an absorbing film and a photomask fabricated with the same.

### Description of the Related Art

Blankmasks used in Extreme Ultraviolet (EUV) lithography generally has two thin films on a substrate: a reflective film that reflects EUV light and an absorbing film that absorbs EUV light. Photomask is fabricated by pattering the absorbing film in the blankmask, which forms the pattern on wafer using the contrast between the reflectance of the reflective film and the reflectance of the absorbing film.

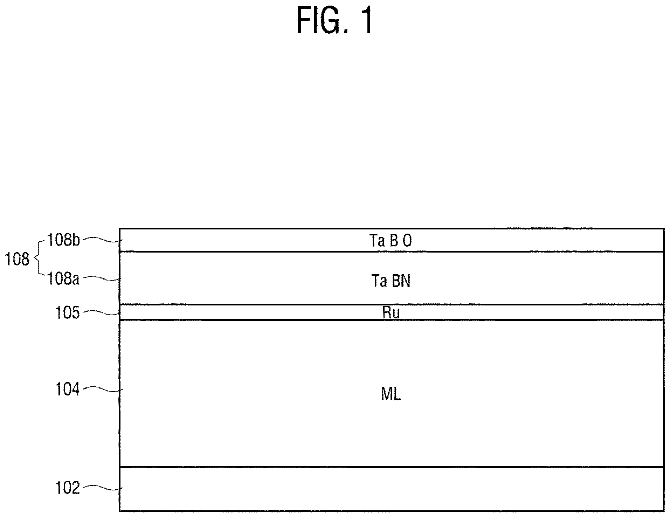

Figure 1 is a diagram illustrating the structure of an Extreme Ultraviolet (EUV) lithography blankmask. The EUV lithography blankmask includes a substrate 102, a reflective film 104 formed on the substrate 102, a capping film 105 formed on the reflective film 104, an absorbing film 108 formed on the capping film 105. A hard mask film (not shown) can be formed on the absorbing film 108, and a resist film (not shown) can be formed on the hard mask film.

The reflective film 104 is formed as a multilayer structure with alternating films of Mo and Si, stacked 40 to 60 times. The capping film 105 is formed on the upper part of the reflective film 104 and serves to protect the reflective film 104 during etching for patterning the absorbing 108. The absorbing 108 is formed on the upper part of the capping film 105 and absorbs the incident EUV light according to the patterned shape for photomask fabrication.

In conventional blankmasks, the absorbing 108 is typically made of a material containing tantalum (Ta) with a high extinction coefficient k to increase the absorption rate of EUV light. Specifically, the absorbing film 108 is formed of a material containing tantalum (Ta) and one or more of boron (B), nitrogen (N), and oxygen (O). The absorbing film 108 can be formed as a two-layer structure with a first layer 108a and a second layer 108b. The second layer 108b contains oxygen (O), resulting in a lower reflectance. This second layer 108b functions as an inspection film with high sensitivity to DUV light.

When using the photomask fabricated with the above-mentioned blankmask for wafer lithography, the incident exposure light enters the photomask at an angle of about 5 to 6 degrees with respect to the vertical direction. As a result, as the thickness of the absorbing film 108 increases, the height of the pattern of the absorbing film 108 becomes higher, leading to an increased Shadowing Effect and a decrease in lithography precision. This issue becomes more significant when forming fine patterns of Logic 3nm or below, especially Logic 2nm or below. Therefore, it is desirable for the absorbing film 108 to have the thinnest possible thickness. However, tantalum (Ta) has an extinction coefficient k of about 0.4 for EUV light with a wavelength of 13.5nm, so it is not possible to fabricate an absorbing film 108 with a high extinction coefficient k, such as 0.5 or higher. Consequently, the conventional Ta absorbing film 108 requires a thickness of at least 55nm to ensure the absorption rate of EUV light, leading to the occurrence of Shadowing Effect due to the thick absorbing film 108.

### SUMMARY

The present invention has been developed to address the aforementioned issues, and it is an object of the invention to provide a blankmask that can mitigate the 3D Effect caused by the thickness of the absorbing film by forming the absorbing film with a material having a higher extinction coefficient (k) compared to the conventional absorbing film. The blankmask for extreme ultraviolet lithography according to the present invention comprises a refective film formed on a substrate, and an absorbing film formed on the reflective film and containing tantalum (Ta) and antimony (Sb).

The absorbing film has a composition ratio of Ta:Sb = 2:8 - 6:4 at%, and preferblay, a composition ratio of Ta:Sb = 3:7 - 5:5 at%.

The absorbing film can further include one or more of nitrogen (N), oxygen (O), and carbon (C).

The absorbing film can further include 5-30 at% of nitrogen (N).

The absorbing film can include a first layer formed on the film, and a second layer formed on the first layer and further including oxygen (O).

The second layer can include 1-50 at% of oxygen (O).

The first layer can further include 5-30 at% of nitrogen (N).

The absorbing film has an extinction coefficient (k) of 0.05 or more for EUV light having a wavelength of 13.5nm.

According to another aspect of the invention, a photomask manufactured using the blankmask for extreme ultraviolet lithography having the above constitution is provided. According to the present invention, it is possible to reduce the thickness of the absorbing film with a high extinction coefficient (k), thereby reducing the Shadowing Effect and 3D Effect. This enables the realization of excellent Wafer Performance.

Furthermore, according to the present invention, the etching rate of the absorbing film is increased, leading to higher productivity in photomask manufacturing and improved side slope of the pattern of the absorbing film.

### BRIEF DESCRIPTION OF THE DRAWINGS

Figure 1 is a diagram illustrating the structure of a conventional blankmask for extreme ultraviolet lithography.
Figure 2 is a diagram illustrating the structure of a blankmask for extreme ultraviolet lithography according to the present invention.

### DETAILED DESCRIPTION OF EXEMPLARY EMBODIMENTS

The following will describe the invention in detail, referring to the attached drawings.

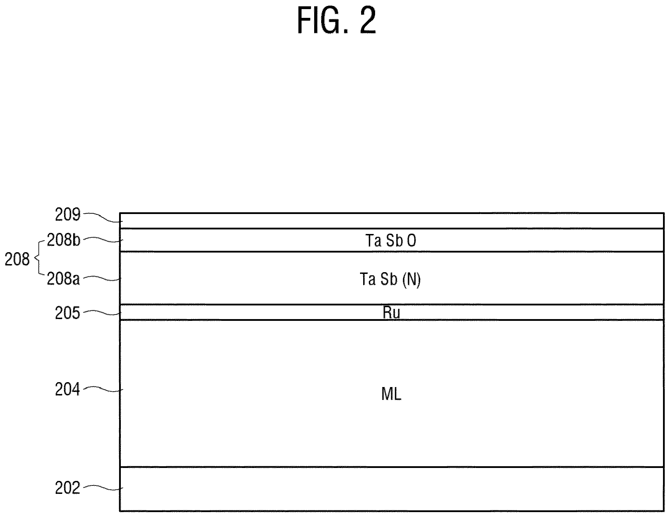

Figure 2 illustrates a diagram of the EUV lithography blankmask according to the present invention.

The EUV lithography phase shift blankmask comprises a substrate 202, a reflective film 204 formed on the substrate 202, a capping film 205 formed on the reflective film 204, an absorbing film 208 formed on the capping film 205, and a hard mask film 209 formed on the absorbing film 208. A resist film (not shown) can be formed on the hard mask film 209.

The substrate 202 is a glass substrate suitable for reflective-type blankmasks using EUV light. It is designed to have a low coefficient of thermal expansion coefficient of 0±1.0×10⁻⁷/°C, preferably within 0±0.3×10⁻⁷/°C, using a Low Thermal Expansion Material (LTEM) glass substrate like SiO₂-TiO₂-based glass to prevent pattern deformation and stress caused by heat during exposure.

The reflective film 204 reflects EUV light and has a multi-layered structure with the refractive indices different from each other. Specifically, it consists of alternating accumulation structure of molybdenum (Mo) layer and silicon (Si) layer for 40 to 60 times. The capping film 205 prevents the formation of an oxide layer on the reflective film 204 to maintain its reflectivity for EUV light, and protects the reflective film 204 during the patterning of the absorbing film 208. It is typically made of a material containing ruthenium (Ru) and has a thickness of 2 to 5nm. The capping film 205 with a thickness of less than 2nm may not effectively perform its function, while a thickness of more than 5nm may reduce the reflectivity for EUV light.

The absorbing film 208 is patterned in the process of manufacturing a photomask from the blankmask. During patterning, the capping film 205 is exposed in the area where the absorbing film 208 is removed. The absorbing film 208 is formed with a material that absorbs EUV light, and materials such as platinum, nickel, tellurium, cobalt, etc. can be considered for this purpose. However, platinum and nickel have very slow etching rates, tellurium has weak chemical resistance, and cobalt tends to introduce defects in the thin film. Considering these drawbacks, the present invention adopts tantalum (Ta) and antimony (Sb) as the constituent materials for the absorbing film 208. Antimony (Sb) provides a suitable etching rate and has fewer defects in the thin film. Antimony (Sb) also has an extinction coefficient k higher than 0.06, enabling the thin-film deposition of the absorbing film 208. Tantalum (Ta) possesses excellent etching characteristics and chemical resistance. Therefore, TaSb absorbing film 208 offers higher performance during photomask fabrication and improves the 3D effect through the thin-film deposition of the absorbing film 208.

It is preferable that the absorbing film 208 has a composition ratio of Ta:Sb = 2:8 - 6:4 at%. When the tantalum (Ta) content exceeds this range, it becomes difficult to achieve a high extinction coefficient k. Additionally, as the antimony (Sb) has somewhat poor chemical resistance, if the antimony (Sb) content is higher than the specified range, it becomes challenging to maintain chemical resistance during the cleaning process. It is more preferable for the absorbing film 208 to have a composition ratio of Ta:Sb = 3:7 - 5:5 at%.

The absorbing film 208 should have an extinction coefficient k of 0.05 or higher, and preferably, it should be 0.06 or higher, for EUV light with a wavelength of 13.5nm.

The absorbing film 208 can contain one or more of nitrogen (N), oxygen (O), and carbon (C). Oxygen functions to reduce the reflectance of the absorbing film 208 for DUV wavelength, making it possible to inspect the absorbing film 208 using DUV light. Nitrogen improves the Line Edge Roughness (LER) during patterning of the absorbing film 208. However, when the nitrogen content is high, the extinction coefficient k decreases, so it is preferable for nitrogen to be present in the range of 1-30 at%.

The absorbing film 208 can be a single layer or a multi-layer structure. When the absorbing film 208 is a single layer, TaSb or TaSbN is preferably used for its formation. If the TaSb absorbing film 208 does not contain oxygen (O), it is etched by chlorine (Cl₂)-based etching gas in the etching process. Specifically, TaSb or TaSbN is etched by chlorine (Cl₂)-based etching gas without oxygen (O₂). As a result, during the etching process of the absorbing film 208, oxygen (O₂) does not contact the capping film 205, thereby preventing damage to the capping film 205.

When the absorbing film 208 is structured as a two-layer film as shown in Figure 2, it includes a first layer 208a formed on the reflective film 204 and capping film 205 and a second layer 208b formed on the first layer 208a. In this case, the first layer 208a does not contain oxygen (O), while the second layer 208b contains oxygen (O). Specifically, the first layer 208a includes tantalum (Ta) and antimony (Sb), and the second layer 208b includes tantalum (Ta), antimony (Sb), and oxygen (O). The first layer 208a may contain nitrogen (N) as well. Preferably, the first layer 208a contains nitrogen (N) at 5-30 at% and the second layer 208b contains oxygen (O) at 1-50 at%. Due to the presence of oxygen (O) in the second layer 208b, its reflectivity decreases, making it function as an inspection film with high sensitivity to DUV inspection light. The second layer 208b of the absorbing film 208 has a reflectivity of 2% or less for 13.5 nm wavelength EUV light, preferably 1.5% or less.

The second layer 208b is etched by fluorine (F)-based etching gas due to the presence of oxygen (O), while the first layer 208a is etched by chlorine (Cl₂)-based gas due to the absence of oxygen (O). In particular, the first layer 208a is etched by chlorine (Cl₂)-based gas without oxygen (O₂). Consequently, during the etching process of the absorbing film 208, fluorine (F) or oxygen (O₂) does not contact the capping film 205, thereby preventing damage to the capping film 205.

The absorbing film 208 has a thickness of 40 nm or less, and preferably 30 nm or less. Since it contains antimony (Sb) with a higher extinction coefficient (k) compared to tantalum (Ta), the absorbing film 208 can be thinner compared to the conventional absorbing film 108 of Figure 1.

The absorbing film 208 according to the present invention has an extinction coefficient (k) of 0.05 or higher, and preferably 0.06 or higher, allowing for a higher extinction coefficient (k) compared to the conventional absorbing film 108 of Figure 1. Therefore, even with a thickness of 40 nm or less, preferably 30 nm or less, the absorbing film 208 of the present invention can achieve sufficient EUV light absorption. Furthermore, the absorbing film 208 of the present invention has an etching rate of 20.1 Å/s, which is over 40% higher than the etching rate of 14.0 Å/s for the conventional absorbing film 108 of Figure 1. This leads to an increased patterning speed for the absorbing film 208, resulting in higher productivity in the photomask manufacturing process. Moreover, the increased etching rate of the absorbing film 208 in the present invention results in significantly improved side slope with an angle of 86° or more for the pattern of the absorbing film 208.

The hard mask film 209 serves as an etching mask to pattern the absorbing film 208. For this purpose, the hard mask film 209 is composed of a material with an etch selectivity to the absorbing film 208. As shown in Figure 2, when the second layer 208b of the absorbing film 208 is composed of TaSbO, it is etched by fluorine (F)-based etching gas. Therefore, the hard mask film 209 is composed of a material etched by chlorine (Cl₂)-based gas. Preferably, the hard mask film 209 includes chromium (Cr) and niobium (Nb). The CrNb hard mask film 209 is etched by chlorine (Clz)-based etching gas without oxygen (O₂), and thus, during the etching process of the first layer 208a, the hard mask film 209 is etched and removed, preventing any damage to the capping film 205 caused by oxygen (O₂).

The process of using the blankmask of the present invention to manufacture a photomask is as follows.

First, the reflective film 204, the capping film 205, the absorbing film 208, and the hard mask film 209 are sequentially formed on the substrate 202. A resist film (not shown) is formed on the hard mask film 209. The resist film is patterned using photolithography, and the patterned resist film is used as an etching mask to pattern the hard mask film 209. The etching process of the hard mask film 209 uses chlorine (Clz)-based etching gas. After patterning the hard mask film 209, the resist film is removed. The resist film can be removed by over-etching the hard mask film 209 without a separate removal process. After removing the resist film, the second layer 208b of the absorbing film 208 is patterned using the hard mask film 209 as an etching mask. Subsequently, the hard mask film 209 and the second layer 208b are used as an etching mask to pattern the first layer 208a. The patterning of the second layer 208b uses fluorine (F)-based etching gas, and the patterning of the first layer 208a uses chlorine (Cl₂)-based etching gas without oxygen (O₂). During the etching process of the first layer 208a, the hard mask film 209 is etched and removed together.

Through this process, the manufacturing process of the photomask using the blankmask of the present invention is completed.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A blankmask for extreme ultraviolet lithography, comprising:
a refective film formed on a substrate, and
an absorbing film formed on the reflective film and containing tantalum (Ta) and
antimony (Sb).

2. The blankmask of claim 1, wherein the absorbing film has a composition ratio of Ta:Sb = 2:8 - 6:4 at%.

3. The blankmask of claim 1, wherein the absorbing film has a composition ratio of Ta:Sb = 3:7 - 5:5 at%.

4. The blankmask of claim 2, wherein the absorbing film further includes one or more of nitrogen (N), oxygen (O), and carbon (C).

5. The blankmask of claim 2, wherein the absorbing film further includes 5-30 at% of nitrogen (N).

6. The blankmask of claim 2, wherein the absorbing film includes,
a first layer formed on the film, and
a second layer formed on the first layer and further including oxygen (O).

7. The blankmask of claim 6, wherein the second layer includes 1-50 at% of oxygen (O).

8. The blankmask of claim 6, wherein the first layer further includes 5-30 at% of nitrogen (N).

9. The blankmask of claim 1, wherein the absorbing film has an extinction coefficient (k) of 0.05 or more for EUV light having a wavelength of 13.5nm.

10. A photomask manufactured using the blankmask for extreme ultraviolet lithography of claim 1.
